# EUROPEAN PATENT APPLICATION

(11) **EP 4 783 753 A1**
(43) Date of publication of application: **29.07.2026**
(21) Application number: 25226322.3
(22) Date of filing: 22.12.2025
(51) Int. Cl.: H05K 1/03, H05K 3/46, H01M 50/519, H05K 1/189

(54) **BATTERY MODULE**

(30) Priority: 23.01.2025 KR 20250010554
(71) Applicant: Samsung SDI Co., Ltd., Yongin-si, Gyeonggi-do 17084 (KR)
(72) Inventor: AHN, Jaepil, 17084 Yongin-si, Gyeonggi-do (KR)
(74) Representative: Gulde & Partner

(57) **Abstract**

A printed circuit board includes a circuit layer including a base film and a conductive layer on at least one surface of the base film, a first cover layer on one surface of the circuit layer, and a flame-retardant layer between the circuit layer and the first cover layer.

## Description

### BACKGROUND

### 1. Technical Field

The disclosure relates to a battery module.

### 2. Description of the Related Art

Secondary batteries are batteries that may be charged and discharged, unlike primary batteries that cannot be recharged. Low-capacity battery cells have been used in small, portable electronic devices, such as smartphones, feature phones, laptop computers, digital cameras, and camcorders, whereas high-capacity battery cells have been widely used as power sources for driving motors in hybrid vehicles, electric vehicles, etc., and batteries for power storage. Battery cells include an electrode assembly including a positive electrode and a negative electrode, a case housing the electrode assembly, and electrode terminals connected to the electrode assembly.

High-capacity battery cells may be used as battery modules in which a large number of battery cells are connected in series and/or parallel to provide high energy density (e.g., for driving a motor in a hybrid vehicle).

### SUMMARY

Embodiments of the disclosure provide a printed circuit board that prevents (or at least mitigates) thermal propagation and a battery module including the printed circuit board.

However, the technical problems to be solved by the disclosure are not limited to the problems described above, and other problems not mentioned may be clearly understood by those skilled in the art from the description of the disclosure described below.

An embodiment of the disclosure provides a printed circuit board including a circuit layer including a base film and a conductive layer on at least one surface of the base film, a first cover layer on one surface of the circuit layer, and a flame-retardant layer between the circuit layer and the first cover layer.

In some embodiments, the printed circuit board may further include a first bonding layer on the flame-retardant layer and a second bonding layer under the flame-retardant layer.

In some embodiments, a thickness of each of the first bonding layer and the second bonding layer may be in a range from about 20 µm to about 100 µm.

In some embodiments, the first bonding layer and the second bonding layer may cover an outer edge of the flame-retardant layer.

In some embodiments, the flame-retardant layer may include one or more through-portions, and the first bonding layer and the second bonding layer may fill the through-portion and contact each other.

In some embodiments, a diameter of the one or more through-portions may be in a range from about 0.1 mm to about 10 mm.

In some embodiments, one or more laminate structures each including the first bonding layer, the flame-retardant layer, and the second bonding layer may be provided.

In some embodiments, the printed circuit board may further include a second cover layer on another surface of the circuit layer that is opposite to the one surface of the circuit layer.

In some embodiments, the flame-retardant layer may include mica, ceramic fiber, glass fiber, and/or silica fiber.

In some embodiments, the flame-retardant layer may include a vacancy in a central portion, and the conductive layer may include a circuit pattern overlapping the flame-retardant layer.

Another embodiment of the disclosure provides a battery module including a two or more battery cells and a printed circuit board electrically connected to the battery cells. The printed circuit board includes a circuit layer including a base film and a conductive layer on at least one surface of the base film, a first cover layer on one surface of the circuit layer, and a flame-retardant layer between the circuit layer and the first cover layer. The first cover layer is adjacent to the battery cells.

In some embodiments, the printed circuit board may further include a first bonding layer on the flame-retardant layer and a second bonding layer under the flame-retardant layer.

In some embodiments, a thickness of each of the first bonding layer and the second bonding layer may be in a range from about 20 µm to about 100 µm.

In some embodiments, the first bonding layer and the second bonding layer may cover an outer edge of the flame-retardant layer.

In some embodiments, the flame-retardant layer may include one or more through-portions, and the first bonding layer and the second bonding layer may fill the through-portion and contact each other.

In some embodiments, a diameter of the one or more through-portions may be in a range from about 0.1 mm to about 10 mm.

In some embodiments, one or more laminate structures each including the first bonding layer, the flame-retardant layer, and the second bonding layer may be provided.

In some embodiments, the printed circuit board may further include a second cover layer on another surface of the circuit layer that is opposite to the one surface of the circuit layer.

In some embodiments, the flame-retardant layer may include mica, ceramic fiber, glass fiber, and/or silica fiber.

In some embodiments, the flame-retardant layer may include a vacancy in a central portion, and the conductive layer may include a circuit pattern overlapping the flame-retardant layer.

### BRIEF DESCRIPTION OF THE DRAWINGS

The following drawings attached to this specification illustrate preferred embodiments of the disclosure and, together with the detailed description of the disclosure described below, serve to further understand the technical idea of the disclosure; therefore, the disclosure should not be interpreted as being limited to matters described in such drawings:
FIG. 1 is an exploded perspective view schematically illustrating an example of a battery module according to an embodiment of the disclosure;
FIG. 2 is a perspective view schematically illustrating an example of a battery cell of the battery module of FIG. 1;
FIG. 3 is a cross-sectional view schematically illustrating a cross-section taken along line III-III' of FIG. 2;
FIG.4 is a perspective view schematically illustrating an example of a printed circuit board of FIG. 1;
FIG.5 is an exploded perspective view schematically illustrating an example of the printed circuit board of FIG.4;
FIG. 6 is a cross-sectional view schematically illustrating a cross-section taken along line IV-IV' of FIG. 4; and
FIG. 7 is a cross-sectional view schematically illustrating a cross-section taken along line V-V' of FIG. 4.

### DETAILED DESCRIPTION

The present disclosure may include various modifications and embodiments, and specific embodiments are illustrated in the drawings and are described in detail in the detailed description. In the following description of the present disclosure, a detailed description of known functions and configurations incorporated herein will be omitted when it may make the subject matter of the present disclosure rather unclear.

It will be understood that, although the terms first, second, etc. may be used herein to describe various components, these components should not be limited by these terms. The terms are used only for the purpose of distinguishing one component from other components.

The terminology used herein is for the purpose of describing particular embodiments only and is not intended to be limiting of the present disclosure. As used herein, the singular forms "a, " "an," and "the" are intended to include the plural forms as well, unless the context clearly indicates otherwise. In addition, in each drawing, components are exaggerated, omitted, or schematically illustrated for convenience and clarity of description, and the size of each component is not entirely reflective.

In the description of each component, in the case in which it is described as being formed "on" or "under," "on" and "under" include all formed directly or with other components therebetween, and the criteria of "on" and "under" will be described with respect to the drawings.

Hereinafter, embodiments of the present disclosure will be described in detail with reference to the accompanying drawings, and in the description with reference to the accompanying drawings, the same or corresponding components are given the same reference numerals, and redundant descriptions thereof will be omitted.

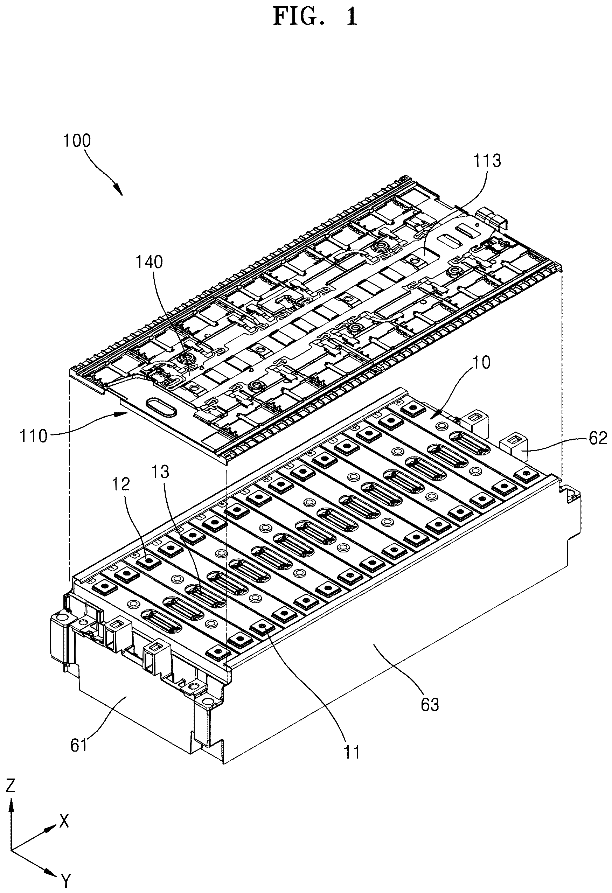

FIG. 1 is an exploded perspective view schematically illustrating an example of a battery module 100 according to an embodiment of the disclosure.

Referring to FIG. 1, the battery module 100 according to an embodiment of the disclosure may include a plurality of battery cells 10 arranged in one direction (e.g., the X-axis direction) and a printed circuit board 140 electrically connecting adjacent battery cells 10 to each other. In one or more embodiments, a busbar may be on the printed circuit board 140.

Each of the battery cells 10 may include a first terminal 11 (which is electrically connected through the busbar on one side), a second terminal 12, and a vent 13 configured to discharge gas occurring or generated internally.

The first terminal 11 may be either a positive electrode terminal or a negative electrode terminal. In an embodiment in which the first terminal 11 is a positive electrode terminal, the second terminal 12 may be a negative electrode terminal, and conversely, in an embodiment in which the first terminal 11 is a negative electrode terminal, the second terminal 12 may be a positive electrode terminal. That is, the first terminal 11 and the second terminal 12 have different electrical polarities and are not limited to a certain polarity.

The first terminal 11 of one battery cell 10 may be electrically connected to the second terminal 12 of another adjacent battery cell 10 through the busbar, and the second terminal 12 of one battery cell 10 may be electrically connected to the first terminal 11 of another adjacent battery cell 10 through another busbar. Although FIG. 1 illustrates a serial connection, the present disclosure is not limited thereto and the battery cells 10 may be connected in any other suitable manner (e.g., in parallel). In addition, the number and arrangement of battery cells 10 are not limited to the structure shown in FIG. 1 and may be changed.

The plurality of battery cells 10 may be accommodated in a housing. The housing may include a pair of end plates 61 and 62 facing a wide surface of outermost (or end most) battery cells 10, side plates 63 connected to the pair of end plates 61 and 62, and a bottom plate.

The side plates 63 may support the side of each of the battery cells 10, and the bottom plate may support a bottom surface of each of the battery cells 10. In addition, the pair of end plates 61 and 62, the side plates 63, and the bottom plate may be joined by a member, such as one or more bolts or other fasteners, but the present disclosure is not limited thereto, and any suitable method for fastening may be utilized.

The battery module 100 may further include a holder 110 on the plurality of battery cells 10 and accommodating the printed circuit board 140 including the busbars.

In one or more embodiments, the holder 110 may be on the plurality of battery cells 10 and may accommodate the busbars through the printed circuit board 140. The holder 110 may include a sensing unit that is configured to perform various protective functions to improve the stability and lifespan of the battery module 100. For example, the sensing unit may be connected to a battery management system (BMS).

Each of the busbars may be equipped with a terminal for temperature measurement and/or a terminal for voltage measurement, and measured information may be transmitted to the sensing unit through wiring and managed in an integrated manner.

Each of the plurality of battery cells 10 may include the vent 13 at the top that is configured to function a gas discharge passage, and the holder 110 may further include holes 113 at least partially overlapping the vents 13. The holes 113 may be discharge passages for high-temperature gas released through the vent 13 in response to the temperature of the battery cell 10 increasing above a predetermined threshold.

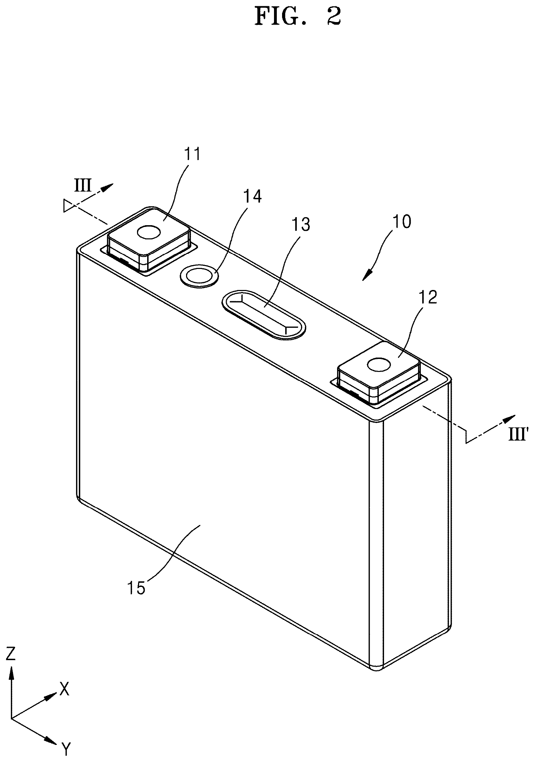

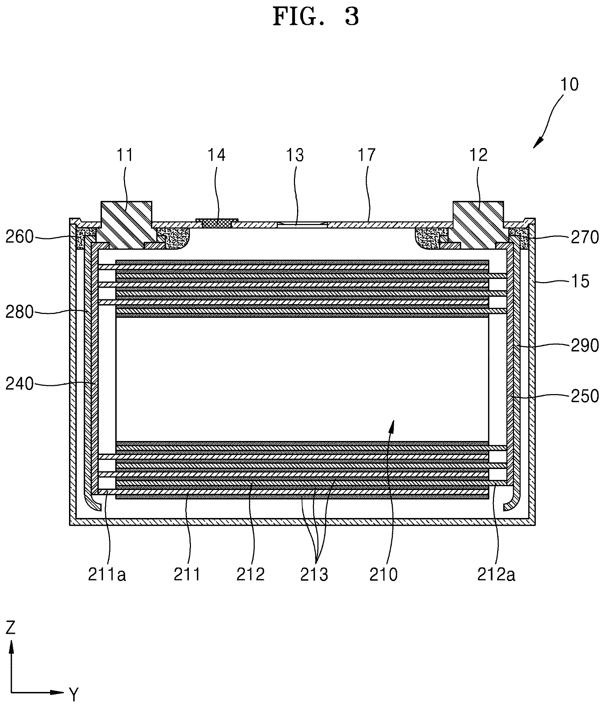

FIG. 2 is a perspective view schematically illustrating an example of a battery cell of the battery module of FIG. 1, and FIG. 3 is a cross-sectional view schematically illustrating an example of a cross-section taken along line III-III' of FIG. 2. Therefore, embodiments and subembodiments shown and described with reference to Figs. 2 and 3 are combinable with embodiments and subembodiments shown and described with reference to Fig. 1.

Referring to FIGS. 2 and 3 together, the battery cell 10 according to one embodiment may include at least one electrode assembly 210 that includes a positive electrode 211, a negative electrode 212, and separator 213 as an insulator between the positive electrode 211 and the negative electrode 212. The positive electrode 211, the negative electrode 212, and the separator 213 may be wound or stacked. The electrode assembly 210 is housed (accommodated) in a case 15.

The battery cell 10 according to the present embodiment is described as a prismatic lithium-ion battery cell as an example. However, the present disclosure is not limited thereto and may be applied to various types of battery cells, such as lithium polymer battery cells or cylindrical battery cells.

The positive electrode 211 and the negative electrode 212 may each include a coated portion, which is a region to which an active material is applied, and uncoated portions 211a and 212a (i.e., positive and negative electrode uncoated portions 211a and 212a, respectively), which are regions to which the active material is not applied. The positive electrode 211 and the negative electrode 212 may each be a current collector including a thin plate (e.g., a metal foil).

In one or more embodiments, the positive electrode 211 and the negative electrode 212 are wound with the separator 213, which is an insulator, therebetween. However, the disclosure is not limited thereto, and the electrode assembly 210 described above may have a structure in which a positive electrode and a negative electrode including a plurality of sheets are alternately laminated with a separator (insulator) therebetween.

The case 15 may form the overall appearance of the battery cell 10 and may include a conductive metal, such as aluminum, an aluminum alloy, or nickel-plated steel. In addition, the case 15 may provide an interior space, in which the electrode assembly 210 is accommodated.

The battery cell 10 may include a cap plate 17 covering an opening of the case 15, and the case 15 and the cap plate 17 may include a conductive material. In one or more embodiments, the first terminal 11 and the second terminal 12, which are electrically connected to the positive electrode 211 and the negative electrode 212, respectively, may protrude outward and penetrate the cap plate 17.

In addition, outer circumferential surfaces of upper pillars of the first terminal 11 and the second terminal 12 protruding outward from the cap plate 17 may be threaded and fixed to the cap plate 17 with a nut.

However, the disclosure is not limited thereto, and the first terminal 11 and the second terminal 12 may have a rivet structure and may be riveted or may be welded to the cap plate 17.

The cap plate 17 may include a thin plate and may be joined to the opening of the case 15, and, in the cap plate 17, an electrolyte injection port 14, into which a sealing plug may be installed, may be formed and the vent 13 may be installed, wherein the vent 13 may have a notch. The notch may be configured to rapture when internal pressure exceeds a predefined threshold thereby releasing the pressure.

The first terminal 11 and the second terminal 12 may be electrically connected to a current collector including first and second current collectors 240 and 250, respectively (hereinafter referred to as positive and negative current collectors, respectively), which are welded to the positive electrode uncoated portion 211a and the negative electrode uncoated portion 212a, respectively.

In one or more embodiments, the first terminal 11 and the second terminal 12 may be joined to the positive and negative current collectors 240 and 250, respectively, by welding. However, the present disclosure is not limited thereto, and the first terminal 11 and the positive current collector 240 may be integral and/or the second terminal 12 and the negative current collector 250 may be integral.

In addition, an insulating material (insulating member) may be between the electrode assembly 210 and the cap plate 17. In one or more embodiments, the insulating member may include first and second lower insulating members 260 and 270, and each of the first and second lower insulating members 260 and 270 may be between the electrode assembly 210 and the cap plate 17. The purpose of the first and second lower insulating members 260 and 270 is to stabilize the respective first terminal 11 and the second terminal 12 and/or to seal the joints between the cap plate 17 and the case 15.

According to one embodiment of the present embodiment, one end of a separating member facing one surface of the electrode assembly 210 may be between the insulating member and the first terminal 11 and between the insulating member and the second terminal 12.

In one or more embodiments, the separating member may include first and second separating members 280 and 290.

Accordingly, one end of each of the first and second separating members 280 and 290 facing one surface of the electrode assembly 210 may be between the first and second lower insulating members 260 and 270 and the first terminal 11 and the second terminal 12, respectively.

As a result, the first terminal 11 and the second terminal 12 welded to the positive and negative current collectors 240 and 250, respectively, may be connected to one end of the first and second lower insulating members 260 and 270, respectively, and to one end of the first and second separating members 280 and 290, respectively.

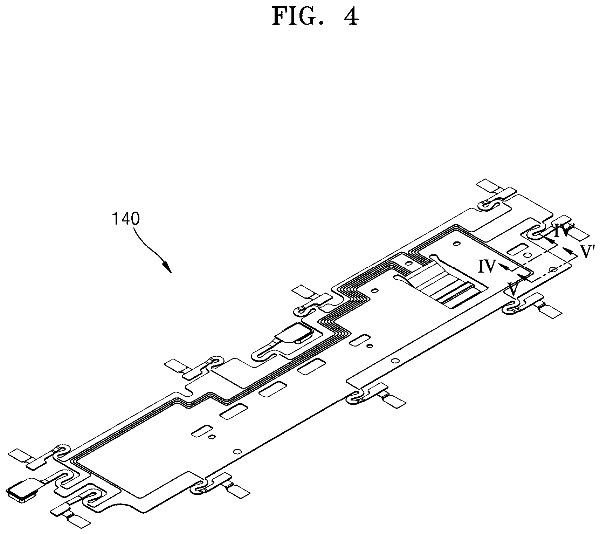

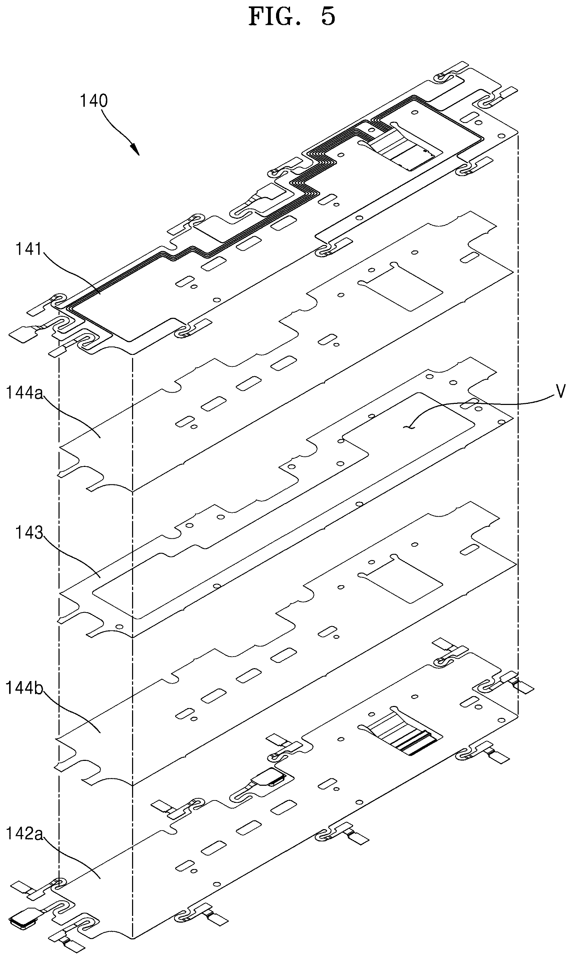

FIG. 4 is a perspective view schematically illustrating an example of the printed circuit board 140 of FIG. 1, and FIG. 5 is an exploded perspective view schematically illustrating an example of the printed circuit board of FIG. 4. Therefore, embodiments and subembodiments shown and described with reference to Figs. 4 and 5 are combinable with embodiments and subembodiments shown and described with reference to Fig. 1.

The printed circuit board 140 includes a circuit layer 141, a first cover layer 142a, and a flame-retardant layer 143.

The circuit layer 141 includes a base film and a conductive layer on at least one surface of the base film.

The first cover layer 142a is on one surface of the circuit layer 141.

The flame-retardant layer 143 is between the circuit layer 141 and the first cover layer 142a.

The base film and/or the first cover layer 142a may include polyimide (PI) (e.g., a polyimide film) and the conductive layer may include copper (Cu).

Because the printed circuit board 140 includes the flame-retardant layer 143 between the circuit layer 141 and the first cover layer 142a, damage to a circuit pattern within the conductive layer that may otherwise occur inside the battery module 100 due to thermal runaway, etc., may be prevented (or at least mitigated), thereby improving the stability of the battery module 100. In one example, the flame-retardant layer 143 may have flame quenching properties and/or self-extinguishing properties. In other words, the flame-retardant layer 143 preferably has poor thermal conductivity.

The printed circuit board 140 may further include a first bonding layer 144a on (above) the flame-retardant layer 143 and a second bonding layer 144b below (under) the flame-retardant layer 143.

The first bonding layer 144a may be between the flame-retardant layer 143 and the circuit layer 141, and the second bonding layer 144b may be between the first cover layer 142a and the flame-retardant layer 143.

The first bonding layer 144a and/or the second bonding layer 144b may include an adhesive material, and due to the adhesive material, the first bonding layer 144a may bond the flame-retardant layer 143 to the circuit layer 141, and the second bonding layer 144b may bond the first cover layer 142a to the flame-retardant layer 143.

In one or more embodiments, a thickness of the first bonding layer 144a and/or the second bonding layer 144b may each be in a range from approximately (about) 20 µm to approximately (about) 100 µm. In one or more embodiments, the thickness of the first bonding layer 144a and the second bonding layer 144b may each be approximately (about) 20 µm.

In an embodiment in which the thickness of the first bonding layer 144a and/or the second bonding layer 144b falls within the above numerical range (approximately (about) 20 µm to approximately (about) 100 µm), durability may be improved, while being economical. If the thickness of the first bonding layer 144a and/or the second bonding layer 144b falls below a lower limit of the numerical range, durability may weaken, and if the thickness of the first bonding layer 144a and/or the second bonding layer 144b exceeds an upper limit of the numerical range, it may not be economically feasible.

In one or more embodiments, the printed circuit board may be a flexible printed circuit board (FPCB).

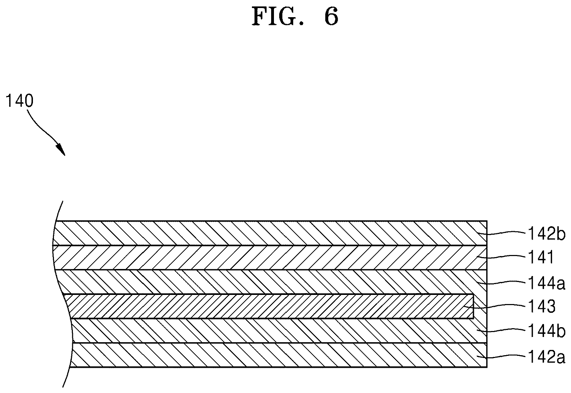

FIG. 6 is a cross-sectional view schematically illustrating an example of a cross-section of the printed circuit board 140 taken along line IV-IV' of FIG. 4.

The printed circuit board 140 may have a laminated structure including a second cover layer 142b, the circuit layer 141, the first bonding layer 144a, the flame-retardant layer 143, the second bonding layer 144b, and the first cover layer 142a stacked sequentially in this order.

The laminated structure of the printed circuit board 140 may be formed through a lamination process (e.g., a single lamination process).

Fine dust may contaminate the flame-retardant layer 143 of the printed circuit board 140 and may cause defects in a joint portion within the battery module 100, and thus there is a problem that a separate coating process may be required for the flame-retardant layer 143.

In one or more embodiments of the present disclosure in which the laminated structure of the printed circuit board 140 is formed through a lamination process, fine dust may be prevented (or at least mitigated) from contaminating the flame-retardant layer 143. In addition, the adhesive strength between the laminated structures may be increased, and there is an effect of forming the laminated structure under low temperature and/or pressure conditions compared to a case in which the laminated structure is formed by a separate bonding process rather than the lamination process.

In one or more embodiments, the lamination process may include a first operation of increasing the temperature from about 70 °C to about 150 °C for about 20 minutes; a second operation of maintaining the temperature at about 150 °C for about 80 minutes; and a third operation of cooling from about 150 °C to about 40 °C for about 20 minutes. In addition, the first operation may be subjected to a pressure of about 30 tons, and the second operation and/or the third operation may be subjected to a pressure of about 105 tons.

In one or more embodiments, in the printed circuit board 140, the first bonding layer 144a and the second bonding layer 144b may cover an outer edge of the flame-retardant layer 143.

Because the first bonding layer 144a and the second bonding layer 144b cover the outer edge of the flame-retardant layer 143, the adhesion of the flame-retardant layer 143 through the first bonding layer 144a and the second bonding layer 144b may be further improved and some of materials constituting the flame-retardant layer 143 may be prevented (or at least mitigated) from being exposed externally. In an embodiment in which the flame-retardant layer 143 includes a mica sheet, there is an effect of preventing some of the threads separated from the mica sheet from being exposed to the outside of the printed circuit board 140.

In addition, the printed circuit board 140 may include at least one laminated structure including the first bonding layer 144a, the flame-retardant layer 143, and the second bonding layer 144b. In one or more embodiments, the printed circuit board 140 may have a laminated structure including the second cover layer 142b, the circuit layer 141, the first bonding layer 144a, the flame-retardant layer 143, the second bonding layer 144b, and the first cover layer 142a sequentially stacked in that order. In one or more embodiments, the printed circuit board 140 may have a laminated structure including the second cover layer 142b, the circuit layer 141, the first bonding layer 144a, the flame-retardant layer 143, the first and second bonding layers 144a and 144b, the flame-retardant layer 143, the second bonding layer 144b, and the first cover layer 142a sequentially stacked in that order. In one or more embodiments, the printed circuit board 140 may have a laminated structure including the second cover layer 142b, the circuit layer 141, the first bonding layer 144a, the flame-retardant layer 143, the first and second bonding layers 144a and 144b, the flame-retardant layer 143, the first and second bonding layers 144a and 144b, the flame-retardant layer 143, the second bonding layer 144b, and the first cover layer 142a sequentially stacked in that order. However, the present disclosure is not limited to these laminated structures.

The printed circuit board 140 may include the first cover layer 142a on one surface (e.g., a lower surface) of the circuit layer 141 and may further include the second cover layer 142b on another surface (e.g., an upper surface) of the circuit layer 141 opposite to the one surface of the circuit layer 141.

The second cover layer 142b may include polyimide (PI) (e.g., a polyimide film).

In one or more embodiments, a portion of the other surface (e.g., the upper surface) of the circuit layer 141 may not include the second cover layer 142b but may instead include (e.g., be at least partially covered by) a metal material (e.g., an aluminum (Al) tab and/or a nickel (Ni) tab).

The flame-retardant layer 143 may include at least one material selected from the group consisting of mica (e.g., a mica sheet), ceramic fiber, glass fiber, and silica fiber.

By including the flame-retardant layer 143 in the printed circuit board 140, the stability of the battery module may be improved by preventing (or at least mitigating) damage to the circuit pattern within the conductive layer that may occur inside the battery module due to thermal runaway, etc.

In one or more embodiments, the thickness of the flame-retardant layer 143 may be in a range from approximately (about) 0.5 mm to approximately (about) 1.5 mm. In one or more embodiments, the thickness of the flame-retardant layer 143 may be in a range from approximately (about) 0.9 mm to approximately (about) 1.1 mm. In one or more embodiments, the thickness of the flame-retardant layer 143 may be approximately (about) 1 mm.

If the thickness of the flame-retardant layer 143 falls within the above numerical range (from approximately (about) 0.5 mm to approximately (about) 1.5 mm), there is an effect of effectively preventing (or at least mitigating) damage to the circuit pattern within the conductive layer economically when a fire occurs within the battery module 100 due to thermal runaway, etc. If the thickness of the flame-retardant layer 143 falls below a lower limit of the numerical range (e.g., below approximately 0.5 mm), a flame-retardant effect may be reduced, and if the thickness of the flame-retardant layer 143 exceeds an upper limit of the numerical range (e.g., above approximately 1.5mm), material costs may increase and/or the volume of the entire battery module 100 may increase and thereby reduce the energy density of the battery module 100.

The flame-retardant layer may include a vacancy V in the central portion, as shown in FIG. 5.

In one or more embodiments, various wirings may be arranged and connected to the printed circuit board 140 through the vacancy V.

In one or more embodiments, the conductive layer may include a circuit pattern overlapping the flame-retardant layer 143.

Because the conductive layer includes a circuit pattern overlapping the flame-retardant layer 143, if a fire, such as thermal runaway, occurs inside the battery module, the flame-retardant layer 143 prevents (or at least mitigates) damage to the circuit pattern within the conductive layer.

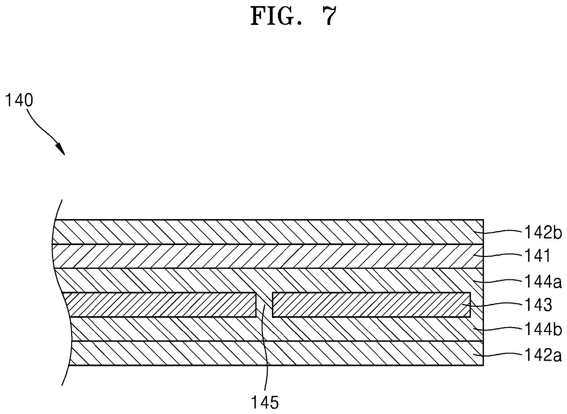

FIG. 7 is a cross-sectional view schematically illustrating an example of a cross-section of the printed circuit board 140 taken along line V-V' in FIG. 4.

In the printed circuit board 140, the flame-retardant layer 143 may include one or more through-portions 145.

In one or more embodiments, the through-portion 145 may refer to any shape penetrating the flame-retardant layer 143, may have any shape connecting one region of one surface of the flame-retardant layer 143 to another region of the other surface of the flame-retardant layer 143, such as, for example, a cylinder, an elliptical cylinder, or a prism penetrating the flame-retardant layer 143, but the present disclosure is not limited thereto.

By filling the through-portion 145, the first bonding layer 144a may contact the second bonding layer 144b. In one or more embodiments, an adhesive material constituting the first bonding layer 144a and the second bonding layer 144b may be applied to the through-portion 145 and then cured under high temperature and/or high pressure conditions such that the first bonding layer 144a may contact the second bonding layer 144b through the through-portion 145 of the flame-retardant layer 143. Accordingly, the through-portion 145 may prevent (or at least mitigate) complete and/or partial peeling of the flame-retardant layer 143.

In one or more embodiments, a diameter of one or more through-portions 145 may be in a range from approximately (about) 0.1 mm to approximately (about) 10 mm. In one or more embodiments, the diameter of one or more through-portions 145 may be approximately (about) 0.1 mm.

In one or more embodiments, the diameter of the through-portion 145 refers to the longest distance between any two points of a closed figure formed by a cross-section of a three-dimensional (3D) shape formed through the through-portion 145 in a plane direction (x-y direction) of the flame-retardant layer 143.

In an embodiment in which the diameter of the through-portion 145 falls within the above numerical range (approximately (about) 0.1 mm to approximately (about) 10 mm), complete and/or partial peeling of the flame-retardant layer 143 may be effectively prevented (or at least mitigated). If the diameter of the through-portion 145 falls below a lower limit of the numerical range (e.g., below approximately 0.1 mm), an increase in adhesive strength may be minimal, and if the diameter of the through-portion 145 exceeds an upper limit of the numerical range (e.g., above approximately 10 mm), an increase in the insulation performance of the flame-retardant layer 143 may be minimal.

According to embodiments of the disclosure, because the printed circuit board included in the battery module includes the flame-retardant layer, damage to the circuit pattern in the conductive layer that may occur inside the battery module due to thermal runaway or the like may be prevented (or at least mitigated), thereby improving the stability of the battery module.

However, the effects obtainable through the disclosure are not limited to the effects described above, and other technical effects not mentioned will be clearly understood by those skilled in the art from the description of the disclosure given below.

## Claims

1. A printed circuit board (140) comprising:
a circuit layer (141) including a base film and a conductive layer on at least one surface of the base film;
a first cover layer (142a) on one surface of the circuit layer (141); and
a flame-retardant layer (143) between the circuit layer (141) and the first cover layer (142a).

2. The printed circuit board (140) of claim 1, further comprising:
a first bonding layer (144a) on the flame-retardant layer (143); and
a second bonding layer (144b) under the flame-retardant layer (143).

3. The printed circuit board (140) of claim 2, wherein a thickness of each of the first bonding layer (144a) and the second bonding layer (144b) is in a range from about 20 µm to about 100 µm.

4. The printed circuit board (140) of claim 2, wherein the first bonding layer (144a) and the second bonding layer (144b) cover an outer edge of the flame-retardant layer (143).

5. The printed circuit board (140) of claim 2, wherein:
the flame-retardant layer (143) includes one or more through-portions (145), and
the first bonding layer (144a) and the second bonding layer (144b) fill the one or more through-portions (145) and contact each other.

6. The printed circuit board (140) of claim 5, wherein a diameter of the one or more through-portions (145) is in a range from about 0.1 mm to about 10 mm.

7. The printed circuit board (140) of claim 2, further comprising one or more laminate structures, each of the one or more laminate structures including the first bonding layer (144a), the flame-retardant layer (143), and the second bonding layer (144b).

8. The printed circuit board (140) of claim 1, further comprising a second cover layer (142b) on another surface of the circuit layer (141) opposite to the one surface.

9. The printed circuit board (140) of claim 1, wherein the flame-retardant layer (143) includes one or more materials selected from the group consisting of mica, ceramic fiber, glass fiber, and silica fiber.

10. The printed circuit board (140) of claim 1, wherein:
the flame-retardant layer (143) includes a vacancy (V) in a central portion, and
the conductive layer includes a circuit pattern overlapping the flame-retardant layer (143).

11. The printed circuit board (140) of claim 1, wherein the flame-retardant layer (143) has flame quenching properties.

12. The printed circuit board (140) of claim 1, wherein the flame-retardant layer (143) has self-extinguishing properties.

13. A battery module (100) comprising:
a plurality of battery cells (10); and
the printed circuit board (140), according to any one of claims 1 to 12, electrically connected to the plurality of battery cells (10).
